# EUROPÄISCHE PATENTSCHRIFT

(11) **EP 2 010 694 B1**
(45) Veröffentlichungstag und Bekanntmachung des Hinweises auf die Patenterteilung: **30.03.2011**
(21) Anmeldenummer: 07728207.7
(22) Anmeldetag: 17.04.2007
(51) Int. Cl.: C23C 16/46, C23C 16/458, C23C 16/52

(54) **VORRICHTUNG UND VERFAHREN ZUR STEUERUNG DER OBERFLÄCHENTEMPERATUR EINES SUBSTRATES IN EINER PROZESSKAMMER**
APPARATUS AND METHOD FOR CONTROLLING THE SURFACE TEMPERATURE OF A SUBSTRATE IN A PROCESS CHAMBER
DISPOSITIF ET PROCÉDÉ DE COMMANDE DE LA TEMPÉRATURE DE SURFACE D'UN SUBSTRAT DANS UNE CHAMBRE DE TRAITEMENT

(30) Priorität: 21.04.2006 DE 102006018514
(43) Veröffentlichungstag der Anmeldung: 07.01.2009
(73) Patentinhaber: Aixtron SE, 52134 Herzogenrath (DE)
(72) Erfinder: KÄPPELER, Johannes, 52146 Würselen (DE); FRANKEN, Walter, 52249 Eschweiler (DE)
(74) Vertreter: Grundmann, Dirk
(86) Internationale Anmeldenummer: PCT/EP2007/053745
(87) Internationale Veröffentlichungsnummer: WO 2007/122147

(56) Entgegenhaltungen:
- DE-A1- 10 056 029
- US-A- 5 318 801
- US-A- 6 001 183

## Beschreibung

Die Erfindung betrifft ein Verfahren zur Steuerung der Oberflächentemperatur eines in einer Prozesskammer eines CVD-Reaktors von einem Substrathalterträger auf einem von einem Gasstrom gebildeten dynamischen Gaspolster getragenen Substrathalter aufliegenden Substrats, wobei die Wärmezufuhr zum Substrat zumindest teilweise durch Wärmeleitung über das Gaspolster erfolgt.

Die Erfindung betrifft darüber hinaus eine Vorrichtung zur Durchführung des Verfahrens mit einer Prozesskammer, einem darin angeordneten Substrathalterträger, ein oder mehreren Substrathaltern, einer Heizung zum Aufheizen des Substrathalterträgers, einer optischen Temperaturmesseinrichtung zur Messung der Oberflächentemperaturen der auf den Substrathaltern aufliegenden Substrate und mit einer Gaszuleitung zur Zuleitung eines Gasstroms zur Erzeugung eines dynamischen Gaspolsters zwischen dem Substrathalterträger und einem Substrathalter.

Eine gattungsgemäße Vorrichtung sowie ein gattungsgemäßes Verfahren beschreibt die US 5,318,801. Beschrieben wird dort ein CVD-Reaktor, bei dem in einer Lageröffnung eines Substrathalterträgers ein Substrathalter auf einem Gaspolster aufliegt. Das Gaspolster wird von einem Gasstrom aus verschieden stark wärmeleitenden Gasen ausgebildet. Die Oberflächentemperatur des Substrathalters soll durch Variation der Gaszusammensetzung variiert werden. Hierzu wird die Oberflächentemperatur des Substrathalters an einer Stelle gemessen.

Die DE 100 56 029 A1 beschreibt einen CVD-Reaktor zum Abscheiden von III-V-Halbleiterschichten auf III-V-Substraten. Die Substrate liegen auf Substrathaltern, welche die Form von Kreiszylinderscheiben haben. Diese Substrathalter liegen in satellitenartiger Anordnung auf einem Substrathalterträger. Der Substrathalterträger besitzt Lagerausnehmungen, die die Substrathalter aufnehmen. Aus dem Boden der Lagerausnehmungen treten Gasströme aus, die den Substrathalter auf einem Gaspolster in der Schwebe halten. Durch eine entsprechende Richtung des aus bodenseitigen Düsen austretenden Gasstroms werden die Substrathalter in eine Drehung versetzt. Bei einem derartigen CVD-Reaktor können sich nicht nur die Substrathalter relativ zum Substrathalterträger drehen. Es ist auch vorgesehen, dass sich der Substrathalterträger selbst um seine eigene Achse dreht.

Der Substrathalterträger kann ebenso wie die Substrathalter aus Graphit bestehen. Es besteht grundsätzlich das Bedürfnis, die Oberflächentemperatur der auf dem Substrathalter aufliegenden Substrate über die gesamte Substratoberfläche konstant zu halten. Die Oberflächentemperatur wird über ein Pyrometer gemessen. Hierzu besitzt die dem Substrathalterträger gegenüberliegende Prozesskammerdecke eine Öffnung. Das Pyrometer ist mit einer Regeleinrichtung verbunden. Diese Regeleinrichtung ermittelt zunächst einmal die mittlere Oberflächentemperatur des Substrates. Diese soll innerhalb eines bestimmten Sollwertbereiches liegen. Die Wärme zur Erzeugung der Oberflächentemperatur des Substrates wird von unten über den Substrathalterträger zugeführt. Hierzu wird letzterer von unten beheizt. Die Wärme wird sowohl über Wärmestrahlung als auch über Wärmeleitung über den das dynamische Gaspolster bildenden Spalt auf den Substrathalter übertragen. Diese Wärme wird von der Substrathalterunterseite an die Substrathalteroberseite, auf welcher das Substrat liegt, geleitet. Das Substrat liegt nur im Idealfall in vollflächiger Anlage auf der Oberfläche des Substrathalters. In der Realität liegt das Substrat oft nur am Rand oder nur im Zentrum auf dem Substrathalter auf. Dies ist eine Folge einer thermisch- oder strukturbedingten Wölbung des Substrates.

Durch Variation der Flussrate des Gasstromes, welcher das Gaspolster bildet, wird die Höhe des Gaspolsters beeinflusst. Einhergehend mit dieser Höheneinstellung wird die Wärmeleitfähigkeit dieses Gasspaltes beeinflusst. Durch Änderung des Gasstroms lässt sich somit der Wärmeübertrag zum Substrat beeinflussen. Mit Hilfe dieser, aus der DE 100 56 029 A1 grundsätzlich bekannten Methode lässt sich zwar die mittlere Oberflächentemperatur des Substrates feinfühlig beeinflussen. Der laterale Temperaturverlauf auf der Oberfläche, also Temperaturinhomogenitäten und insbesondere Horizontal-Gradienten können mit dieser Methode nur beschränkt beeinflusst werden.

Aus der DE 10133 914 A1 ist eine Vorrichtung zum Abscheiden von Schichten auf Substraten bekannt, bei der eine Vielzahl von Substrathalters in topfförmigen Aussparungen eines Substrathalterträgers einliegen. Die Substrathalter werden jeweils von einem Gaspolster getragen.

Aus der DE 696 29 980 T2 ist eine Methode zur Temperaturregelung zum Abscheiden eines Werkstoffs vorbekannt. Das Substrat liegt oberhalb eines Kühlblocks. Zwischen Substrat und Kühlblock besteht ein Spalt, der mit Gasen unterschiedlicher Wärmeleitfähigkeit gespült wird.

Die DE 69117 824 T2 beschreibt ein Verfahren, bei dem die Rückseite eines Substrates mit einem Gemisch von Argon und Wasserstoff gespült wird.

Die US 5,683,759 beschreibt ein Verfahren zum Abscheiden polycrystalliner Diamanten auf einem Substrat, wobei ein Substrathalter verschieden tiefe Ringnuten aufweist.

Aus der WO 2005/121417 A1 ist eine CVD-Einrichtung bekannt, bei der die Substrate auf einem drehbaren Substrathalter aufliegen. Der Substrathalter liegt auf einem Gaspolster auf.

Der Erfindung liegt die Aufgabe zugrunde, ausgehend vom gattungsgemäßen Stand der Technik die laterale Homogenität der Oberflächentemperatur des Substrates zu verbessern.

Gelöst wird die Aufgabe durch die in den Ansprüchen 1 und 12 angegebene Erfindung. Die Unteransprüche stellen vorteilhafte Weiterbildungen dar.

Der das Gaspolster bildende Gasstrom wird von zwei oder mehr Gasen mit unterschiedlich hoher spezifischer Wärmeleitfähigkeit gebildet. Die Wärmeleitfähigkeit des dynamischen Gaspolsters wird durch die Zusammensetzung dieses Gasstromes variiert. Die Wärmeleitfähigkeit kann auch (zusätzlich) durch eine Erhöhung der Strömungsgeschwindigkeit variiert werden. Bei einer Erhöhung des Gasstroms und der damit einhergehenden Vergrößerung des Gaspolsters sinkt die Oberflächentemperatur im wesentlichen gleichmäßig über den gesamten Durchmesser des Substrathalters. Der qualitative Verlauf des Temperaturprofils über die Fläche und insbesondere über den Durchmesser wird durch diese Maßnahme nur geringfügig verändert. Überraschenderweise hat sich gezeigt, dass die Änderung der Wärmeleitfähigkeit des das Gaspolster bildenden Gases eine Beeinflussung des Temperaturprofils als solches ermöglicht. Es hat sich nämlich gezeigt, dass mit zunehmender Steigerung der Leitfähigkeit des Gaspolsters die Temperatur im Zentrum der Oberfläche des Substrathalters stärker ansteigt als am Rand. Mit der Variation der Wärmeleitfähigkeit des dynamischen Gaspolsters ist somit eine Feineinstellung des Verlaufs der Temperatur auf der Substrathalteroberfläche möglich. Die erfindungsgemäße Möglichkeit der Feineinstellung der Wärmeleitfähigkeit bildet somit die Möglichkeit, die Temperatur zu beeinflussen, ohne dass sich die Dicke des Gaspolsters ändert. Dies ist insbesondere dann von Vorteil, wenn die beiden stark verschieden wärmeleitenden Gase auch stark verschiedene Viskositäten besitzen. Es ist ferner vorgesehen, dass der Substrathalter eine Wärmeleitfähigkeit besitzt bzw. der Substrathalter und die Lagerausnehmung eine derartige Gestalt besitzen, dass die Oberflächentemperatur des Substrathalters bei der Verwendung von nur einem der beiden Gase eine laterale Inhomogenität aufweist, die durch Änderung der Zusammensetzung ausgleichbar und insbesondere überkompensierbar ist. Die

Wärmeleitfähigkeit des Substrathalters kann eine radiale Inhomogenität besitzen. Es ist aber vorgesehen, dass der Substrathalter in Bezug auf die Wärmeleitfähigkeit eine Rotationssymmetrie besitzt. Die aufeinander zuweisenden, das Gaspolster begrenzenden Flächen von Substrathalterunterseite einerseits und Bodenfläche der Lagerausnehmung andererseits besitzen auch eine besondere insbesondere rotationssymmetrische Struktur. Diese beiden Flächen können eine Gestalt besitzen, die von der Gestalt einer Ebene abweicht. Das Gaspolster kann an verschiedenen Radialpositionen unterschiedliche Dicken besitzen.

So kann beispielweise vorgesehen sein, dass bei der Verwendung von Stickstoff als Trägergas, welches gegenüber Wasserstoff schlechtleitend ist, die Substrathalteroberflächentemperatur in der Mitte geringer ist als am Rand. Wird dagegen als Gaspolster erzeugendes Gas Wasserstoff verwendet, so ist die Oberflächentemperatur des Substrathalters in der Mitte höher als am Rand. Durch eine geeignete Mischung der beiden Gase untereinander kann der Temperaturverlauf über eine Diagonale auf dem Substrathalter derart eingestellt werden, dass die Abweichungen der einzelnen Radialpositionstemperaturen vom Mittelwert minimiert sind. Idealerweise lässt sich somit ein flach verlaufendes Temperaturprofil auf der Substrathalteroberfläche einstellen. Letzteres gilt auch für die Oberflächentemperatur eines auf dem Substrathalter aufliegenden Substrates. Wölbt sich dieses während des Prozesses, so können die damit einhergehenden lokalen Änderungen der Wärmetransporteigenschaften vom Substrathalter zum Substrat durch eine entsprechende Änderung der Gaszusammensetzung kompensiert werden. Hebt sich beispielsweise das Zentrum des Substrates zufolge einer thermischen Durchbiegung des Substrates vom Substrathalter ab, so kann durch Variation der Gaszusammensetzung der Wärmeübertrag im Zentrum erhöht werden. In analoger Weise ist es möglich, den verminderten Temperaturübertrag am Rand auszugleichen, wenn sich die Ränder des Substrates zufolge einer Wölbung des Substrates von der Substrathalteroberfläche abheben. Optimal lassen sich derartige Effekte dadurch kompensieren, dass bei der Verwendung nur eines stark wärmeleitenden Gases der Zentralbereich des

Substrathalters wärmer ist als der Randbereich bzw. dass bei Nurverwendung eines schwach wärmeleitenden Gases der Zentralbereich des Substrathalters kälter ist als der Randbereich. Es können auch Substrathalter verwendet werden, deren Wärmeleiteigenschaften in Achsrichtung lokal unterschiedlich sind. So kann die Wärmeleiteigenschaft in Achsrichtung im Zentrum eine andere sein als am Rand des Substrathalters. Dies gilt auch für die Wärmestrahlungseigenschaften, die für die Energieübertragung im Wege der Wärmestrahlung verantwortlich sind. Auch diese können an unterschiedlichen Radialpositionen verschieden sein. Die Wärmestrahlungseigenschaften sind im wesentlichen Oberflächeneigenschaften. Es ist also vorgesehen, dass die Oberfläche des Bodens der Lagerausnehmung und die Oberfläche der Substrathalterunterseite lokal andere Wärmestrahlungseigenschaften aufweisen können. In einer bevorzugten Ausgestaltung haben die Substrathalter aber in Radialrichtung unterschiedliche Materialstärken. Beispielsweise kann der Substrathalter in der Mitte dünner sein als am Rand. Hierzu kann die Unterseite des Substrathalters eine Wölbung aufweisen. Es können eine konkave und eine konvexe Wölbung vorgesehen sein. In analoger Weise kann auch der Boden der Lagerausnehmung entweder konvex oder konkav gewölbt sein. Es ist aber auch vorgesehen, dass der Substrathalter eine gestufte Ausnehmung auf seiner Unterseite besitzt.

Die Vorrichtung zur Durchführung des Verfahrens entspricht im wesentlichen derjenigen, die von der DE 10056029 A1 beschrieben wird. Außerdem kann das erfindungsgemäße Verfahren auch mit einer Variation der Gasströme zur Variation der Höhe des Gaspolsters durchgeführt werden.

Die Vorrichtung zur Durchführung des Verfahrens besitzt eine unterhalb des Substrathalterträgers angeordnete Heizung. Es kann sich hier um eine Widerstandsheizung handeln. Diese erwärmt den Substrathalterträger. Über Wärmeleitung und Wärmestrahlung wird der Substrathalter erwärmt. Die Oberflächentemperatur des auf dem Substrathalter aufliegenden Substrates wird ständig gemessen. Da der Substrathalter gedreht wird, wird eine mittlere Temperatur gemessen. Die Radialabhängigkeit der Temperatur ist aber feststellbar. Grundsätzlich reicht ein Pyrometer zur Messung der Temperatur aus, wenn der Substrathalterträger um seine Achse gedreht wird. Die Messwerte des Pyrometers werden einer Regeleinrichtung zugeführt. Diese Regeleinrichtung steuert Massenflussmessgeräte, die die Gaszusammensetzung des Gasstromes steuert, welcher das Gaspolster ausbildet. Dabei wird in der Regel der Gesamtgasstrom pro Zeit konstant gehalten, so dass die Höhe des Gaspolsters konstant bleibt. Es ist aber auch möglich, dass zusätzlich durch Variation des Gesamtflusses die Höhe des Gaspolsters variiert wird.

Ausführungsbeispiele der Erfindung werden nachfolgend anhand beigefügter Zeichnungen erläutert. Es zeigen:
- Fig.1: die Draufsicht auf einen Substrathalterträger, mit insgesamt fünf in La- gerausnehmungen einliegenden Substrathaltern zur jeweiligen Auf- nahme eines Substrates;
- Fig. 2: schematisch einen Teilschnitt durch die Prozesskammer entlang der Linie II - II;
- Fig. 3: eine Darstellung gemäß Fig. 2 einer alternativen Gestaltung eines Sub- strathalters;
- Fig. 4: qualitativ die Temperaturverläufe über eine Diagonale auf dem Sub- strat, bei unterschiedlichen Gaszusammensetzungen des das dynami- sche Gaspolster bildenden Gasstroms und

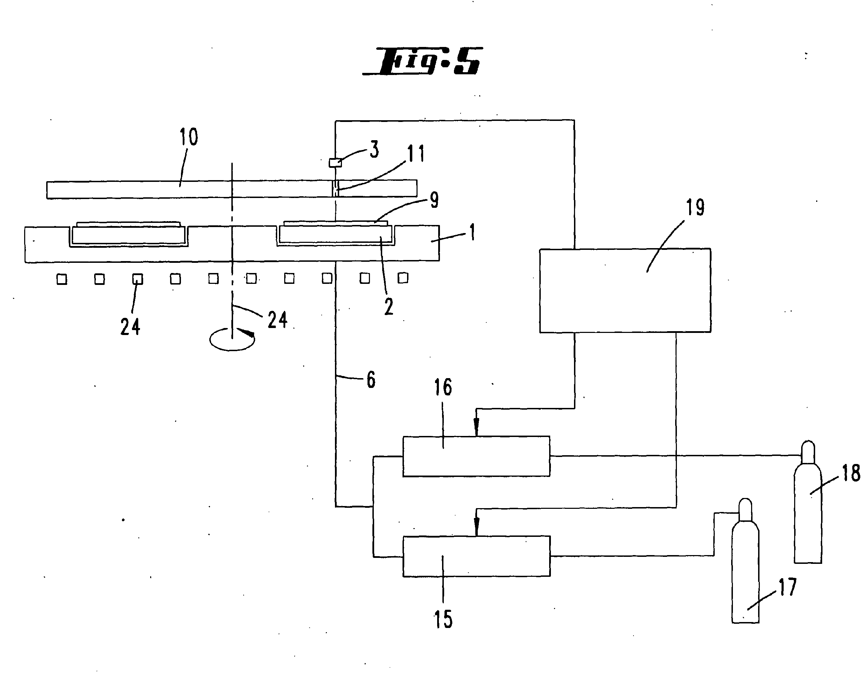

- Fig. 5: in schematischer Darstellung die Peripherie des Reaktors.

Das erfindungsgemäße Verfahren wird in einer Prozesskammer 12 eines CVD-Reaktors durchgeführt. Die Prozesskammer 12 befindet sich zwischen einem sich in Horizontalrichtung erstreckenden Substrathalterträger 1, der einen kreisförmigen Grundriss besitzt und um seine Achse 14 drehangetrieben werden kann, und einer parallel oberhalb des Substrathalterträgers 1 sich befindenden Prozesskammerdecke 10. Die Prozesskammer befindet sich zwischen Decke 10 und Substrathalterträger 1. Der Substrathalterträger 1 wird von unten mittels einer Widerstandsheizung 24 beheizt. Auf der Oberseite des Substrathalterträgers 1 sind insgesamt fünf Lagerausnehmungen 20 vorgesehen. In jeder der topfförmigen Lagerausnehmungen 20 liegt ein kreisscheibenförmiger Substrathalter 2 ein. Im Boden 21 der Lagerausnehmung 20 befinden sich Spiralnuten 7, in welche Gaszuleitungen 6 münden. Das aus den Spiralnuten 7 austretende Gas hebt den Substrathalter 2 an und lagert ihn auf einem dynamischen Gaspolster 8. Die Gase treten aus der Spiralnut 7 mit einer bestimmten Richtung aus, die geeignet ist, den Substrathalter 2 drehanzutreiben, so dass er um seine eigene Achse dreht. Auf jedem der Substrathalter 2 liegt ein Substrat 9. Die gesamte Prozesskammer steckt in einem nicht dargestellten Reaktorgehäuse und ist gegenüber der Umwelt hermetisch abgeschottet, so dass die Prozesskammer 12 evakuiert werden kann.

Zur Durchführung des CVD-Prozesses werden Prozessgase benötigt, die durch nicht dargestellte Zuleitungen in die Prozesskammer 12 eingeleitet werden. Diese Prozessgase können metallorganische Verbindungen beinhalten. Sie können auch Hydride beinhalten. Es können auch Metallchloride sein. Auf der Oberfläche der Substrate 9 soll eine einkristalline Schicht abgeschieden werden. Es kann sich hier um Materialien der Hauptgruppe IV oder Materialien der III-und V-Hauptgruppe oder Materialien der II- und VI-Hauptgruppe handeln. Das Substrat 9 kann aus jedem geeigneten Material bestehen. Es kann ein Nichtleiter oder ein Halbleiter sein. Nur im Idealfall werden gitterangepasste Schichten auf die einkristalline Oberfläche des Substrates abgeschieden. Nur im Idealfall haben die abgeschiedenen Schichten und das Substrat denselben Wärmeausdehnungskoeffizienten. Im Regelfall sind die Schichten nicht zu 100% gitterangepasst. Die einzelnen Schichten haben auch unterschiedliche Wärmeausdehnungskoeffizienten. Insbesondere besitzen die Schichten größere oder kleine Wärmeausdehnungskoeffizienten. Dies hat zur Folge, dass bei einer Temperaturänderung des Substrates im Bereich der Schichten oder der Grenzfläche Spannungen auftreten, die zu einer Wölbung des Substrates führen. Auch das Abscheiden von nicht gitterangepassten Schichten kann zu Verspannungen und damit zu Wölbungen des Substrates 9 führen. Je nach Verschiedenheit der Gitterkonstanten bzw. der Temperaturausdehnungskoeffizienten kann sich das Zentrum des Substrates 9 nach oben oder nach unten wölben. Da die Abscheidungsprozesse innerhalb der Prozesskammer 12 bei verschiedenen Temperaturen durchgeführt werden, kann sich die Wölbung des Substrates 9 während eines Prozesses auch umkehren, so dass in einem Prozessabschnitt nur der Zentralbereich des Substrates 9 berührend auf der Oberfläche des Substrathalters 2 aufliegt und in einem anderen Prozessabschnitt nur der Rand des Substrates 9 berührend auf der Oberfläche des Substrathalters 2 aufliegt. Dies hat zur Folge, dass der Wärmefluss von der Oberfläche des Substrathalters 2 hin zum Substrat 9 lateral unterschiedlich ist und zeitlich variiert.

Wenn die Prozesskammer 12 nur von unten beheizt wird, bildet sich dort ein vertikaler Temperaturgradient aus. Das bedeutet, die Temperatur in der Gasphase oberhalb des Substrates 9 nimmt mit steigendem Abstand vom Substrathalter 2 ab. Wegen des fehlenden Kontaktes des Substrates 9 an einzelnen Stellen zur Oberfläche des Substrathalters 2 kommt es hier zu einer verminderten Wärmeübertragung vom Substrathalter 2 zum Substrat 9. Dies hat zur Folge, dass bestimmte Bereiche des Substrates 9 kälter sind als andere Bereiche. Dies ist nicht erwünscht. Erwünscht ist vielmehr eine über die gesamte Fläche des Substrates 9 gleichbleibende Oberflächentemperatur, so dass der Temperaturgradient in Horizontalrichtung minimal ist. Die Isotherme unmittelbar über der Oberfläche des Substrates 9 soll möglichst flach verlaufen. Die Substratoberfläche soll idealerweise auf einer Isothermen liegen.

Der Wärmeübertrag vom Substrathalterträger 1 zum Substrathalter 2 erfolgt im wesentlichen über das dynamische Gaspolster 8. Hier spielt sowohl die Wärmestrahlung vom Boden 21 der Lagerausnehmung 20 zur Unterseite des Substrathalters 2 als auch die Wärmeleitung über das wärmeleitende Gas, welches das Gaspolster 8 ausbildet, eine Rolle.

Durch eine unterschiedliche Gestaltung von sowohl Oberfläche des Bodens 21 als auch Unterseite des Substrathalters 2 kann der Wärmeübertrag durch Strahlungswärme beeinflusst werden. Die Wärmeübertragung durch Wärmeleitung kann durch Variation der Höhe des dynamischen Gaspolsters 8 variiert werden. Hierzu kann der Gesamtgasstrom durch die Zuleitung 6 erhöht oder erniedrigt werden. Mit diesen Maßnahmen kann aber nicht während des Prozesses der laterale Verlauf der Isothermen unmittelbar oberhalb des Substrates 9 bzw. der laterale Temperaturgradient der Oberflächentemperatur des Substrates 9 beeinflusst werden.

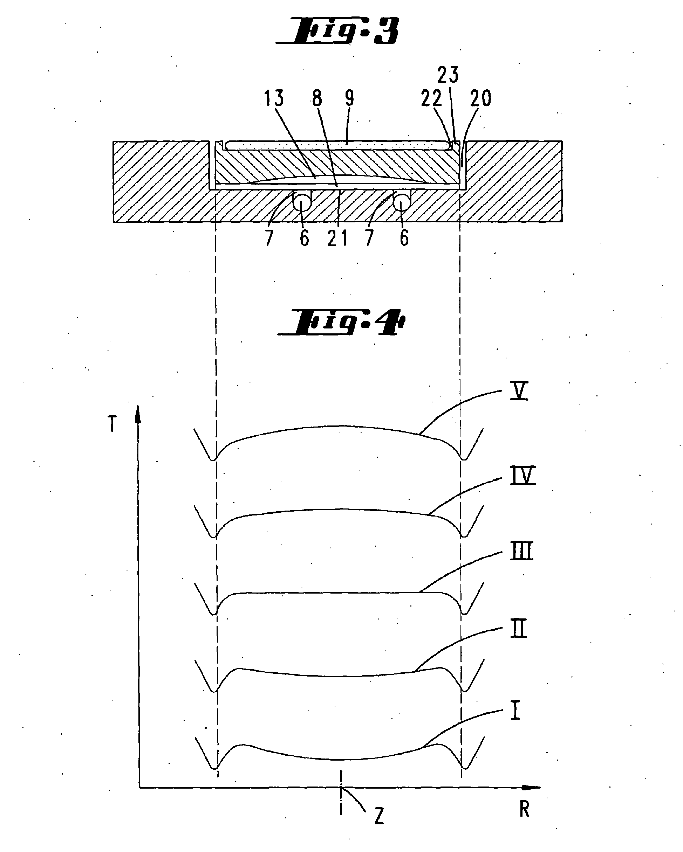

Erfindungsgemäß ist vorgesehen, dass dies mit Hilfe einer Variation der Zusammensetzung des Gases erfolgt, welches das dynamische Gaspolster 8 erzeugt. Es werden zwei Gase 17,18 verwendet, die einen hohen Unterschied hinsichtlich ihrer spezifischen Wärmeleitfähigkeit aufweisen. So kann beispielsweise stark wärmeleitender Wasserstoff 17 mit schwach wärmeleitendem Stickstoff 18 gemischt werden. Hierzu dienen Massenflusscontroller 15, 16 individuell für jedes der beiden Gase 17, 18. Es können aber auch andere Gasmischungen, insbesondere geeignete Edelgase wie Argon, Helium etc. verwendet werden. Die beiden unterschiedlichen Gase 17,18 werden mit einer gemeinsamen Zuleitung 6 in die Lagerausnehmungen 20 geleitet. Durch Variation der Zusammensetzung der Gase, die mit Hilfe der Massenflusscontroller 15 und 16 erfolgt, kann die Wärmeleitfähigkeit des Gaspolsters 8 variiert werden. Die Höhe des Gaspolsters 8 bleibt dabei im wesentlichen unverändert. Zur Einstellung der Gasflüsse 15,16 ist eine Regeleinrichtung 19 vorgesehen. Diese Regeleinrichtung 19 bekommt ihre Eingangsdaten von einem Pyrometer 3, welches durch eine Öffnung 11 die Substratoberflächentemperatur misst. Es wird eine gemittelte Oberflächentemperatur gemessen, da sich der Substrathalter 2 dreht. Zufolge der Eigendrehung des Substrathalterträgers 1 wandert ein Substrathalter 2 nach dem anderen unter der Öffnung 11 hindurch. Da diese denselben Radialabstand zur Drehachse 14 besitzt wie die Drehachse des Substrathalters 2, wird ein Diagonaltemperaturverlauf gemessen, wie er beispielsweise in der Figur 4 dargestellt ist.

Durch eine geeignete konstruktive Gestaltung oder durch eine geeignete Masterialauswahl kann der Substrathalter 2 so gestaltet werden, dass bei Verwendung nur eines schwach wärmeleitenden Gases 18 der Randbereich der Substrathalteroberfläche heißer wird als der Zentralbereich. Dies ist in der Figur 4 durch die Kurve I dargestellt. Verändert man das Mischungsverhältnis des Gases dahingehend, dass man durch Zugabe von mehr Wasserstoff 17 und Rücknahme von Stickstoff 18 die Wärmeleitfähigkeit des Gases erhöht, so erwärmt sich der Zentralbereich der Oberfläche des Substrathalterträgers 1 in höherem Maße. Dies ist mit der Kurve II angedeutet und auf einen überraschenden Effekt zurückzuführen. Eine weitere Erhöhung der Wärmeleitfähigkeit des Gaspolsters 8 führt dann dazu, dass - wie in der Kurve III dargestellt - die Temperatur der Substrathalteroberfläche über die gesamte Radialerstreckung im wesentlichen gleich ist. Dies ist ein Sollzustand, wenn das Substrat 9 in idealer Weise flächig auf der Oberfläche des Substrathalters 2 aufliegt.

Durch weitere Änderung des Mischungsverhältnisses hin zu einer hohen Leitfähigkeit des Gases wird ein Temperaturverlauf erreicht, wie ihn die Kurve IV darstellt. Fließt nur Wasserstoff 17 durch die Zuleitung 6, kann ein Temperaturverlauf wie ihn die Kurve V darstellt, erreicht werden. Ein Temperaturverlauf der Substrathalteroberfläche, wie ihn die Kurven I und II darstellen, ist dann erforderlich, wenn das Substrat 9 nur mit seinem Zentralbereich auf der Oberfläche des Substrathalters 2 aufliegt. Dann muss die Temperatur des Substrathalters 2 im Randbereich höher sein, um dort die verminderte Wärmeleitung zum Substrat 9 auszugleichen. Die Temperaturverläufe gemäß den Kurven IV und V sind dann von Bedeutung, wenn das Substrat 9 nur mit dem Randbereich auf der Oberfläche des Substrathalters 2 aufliegt. Jetzt muss die verminderte Wärmeleitung im Zentralbereich durch eine höhere Oberflächentemperature kompensiert werden.

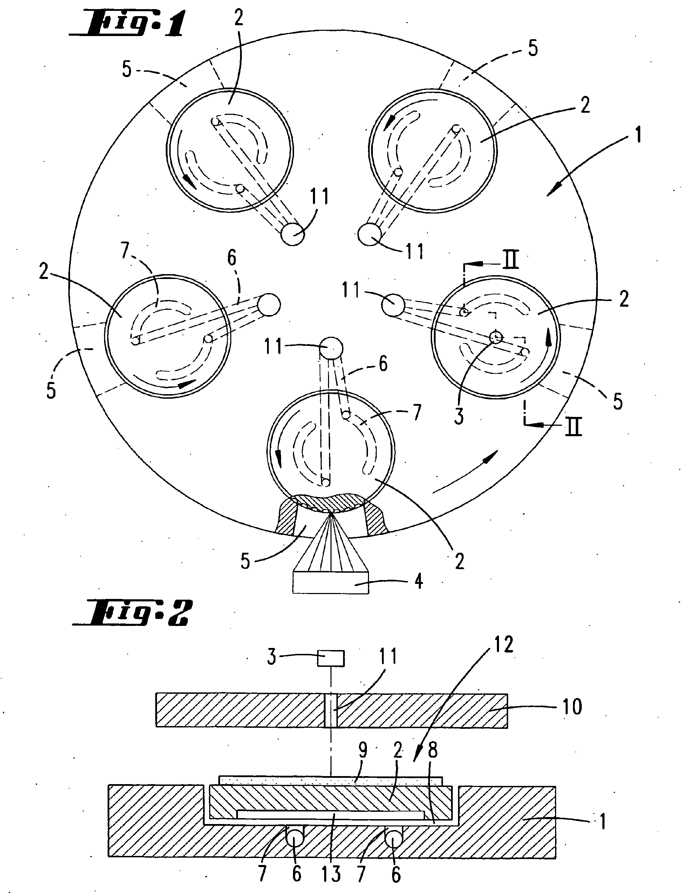

Bei dem in der Figur 2 dargestellten Substrathalter besitzt die Unterseite des Substrathalters 2 eine Aussparung 13. Es handelt sich hier um eine zentrale, topfförmige Aussparung 13, die zu einer Vergrößerung der Höhe des Gaspolsters 8 führt. Dies hat einen verminderten Wärmetransport durch Wärmeleitung vom Boden 21 zum Substrathalter 2 zur Folge. Die damit einhergehende Inhomogenisierung der Oberflächentemperatur kann durch eine entsprechende Zusammensetzung der Gase kompensiert werden.

Bei dem in Figur 3 dargestellten Ausführungsbeispiel ist diese Aussparung 13 als Mulde dargestellt. Der Boden der Mulde 13 geht ohne Stufe in die ebene Ringfläche der Unterseite des Substrathalters 2 über.

Es wird als besonders vorteilhaft erachtet, dass bei einer Kombination der Variation der Gaszusammensetzung und einer gleichzeitigen Erhöhung des Gasdrucks nicht nur der Verlauf der Oberflächentemperatur, sondern auch der absolute Wert der Oberflächentemperatur beeinflusst werden kann. Hierdurch ist es möglich, um einen konstanten Mittelwert herum die Randtemperatur gegenüber der Zentraltemperatur abzusenken oder zu erhöhen, wobei die Randtemperatur des Substrathalters 2 sowohl über als auch unter der Zentraltemperatur der Substratoberfläche liegen kann. Der Temperaturverlauf auf der Substrathalteroberfläche wird idealerweise von der Regeleinrichtung 19 über die Variation der Massenflüsse 15,16 so eingestellt, dass die Substratoberfläche an jeder Stelle möglichst dieselbe Temperatur besitzt.

## Patentansprüche

1. Verfahren zur Steuerung der Oberflächentemperatur mindestens eines in einer Prozesskammer (12) eines CVD-Reaktors in einer Lagerausnehmung (20) eines Substrathalterträgers (1) einliegenden, auf einem von einem Gasstrom gebildeten dynamischen Gaspolster (8) getragenen Substrathalter (2) aufliegenden Substrats (9), wobei der das Gaspolster (8) zwischen der Bodenfläche der Lagerausnehmung (20) und der Unterseite des Substrathalters (2) ausbildende Gasstrom von zwei oder mehr Gasen (17,18) mit unterschiedlich hoher spezifischer Wärmeleitfähigkeit gebildet wird, und die Wärmezufuhr zum Substrat (9) zumindest teilweise durch Wärmeleitung über das Gaspolster erfolgt und die Oberflächentemperatur des Substrats auf der Substratoberfläche gemessen und die Wärmeleiteigenschaft des Gaspolsters durch Variation der Gaszusammensetzung beeinflusst wird, **dadurch gekennzeichnet, dass** die Oberflächentemperatur des Substrats an einer Vielzahl von Stellen gemessen wird und durch Variation der Gaszusammensetzung abhängig von den gemessenen Oberflächentemperaturen die Abstände dieser Temperaturen von einem Mittelwert vermindert werden, wobei die Wärmeleitfähigkeit des Substrathalters (2) so gewählt ist und die Unterseite des Substrathalters (2) sowie die Bodenfläche der Lagerausnehmung (20) so gestaltet sind, dass die Oberflächentemperatur des Substrats bei der Verwendung nur eines der beiden Gase (17, 18) eine rotationssymmetrische laterale Inhomogenität aufweist, die durch Änderung der Zusammensetzung des Gasstroms ausgeglichen oder überkompensiert wird.

2. Verfahren nach Anspruch 1, **dadurch gekennzeichnet, dass** durch die Variation der Gaszusammensetzung der laterale Temperaturverlauf auf der Oberfläche des Substrathalters (2) derart beeinflusst wird, dass die Temperatur auf der Substratoberfläche über im wesentlichen die gesamte Substratoberfläche konstant ist.

3. Verfahren nach einem der vorangehenden Ansprüche, **dadurch gekennzeichnet, dass** bei Verwendung nur eines Gases (17,18) insbesondere des stark wärmeleitenden Gases der Zentralbereich des Substrathalters (2) wärmer ist als der Randbereich.

4. Verfahren nach einem der Ansprüche 1 bis 2, **dadurch gekennzeichnet, dass** bei Verwendung nur eines Gases (17,18), insbesondere des schwach wärmeleitenden Gases der Zentralbereich des Substrathalters (2) kälter ist als der Randbereich.

5. Verfahren nach einem der vorangehenden Ansprüche, **dadurch gekennzeichnet, dass** durch Variation der einzelgesteuerten, die Gaspolster (8) erzeugenden Gasströme einzelner einer Vielzahl von einem Substrathalterträger (1) zugeordneten Substrathaltern (2) die Höhen der Gaspolster (8) so eingeregelt werden, dass die gemessenen Mittelwerte innerhalb eines vorgegebenen Temperaturfensters liegen.

6. Verfahren nach einem der vorangehenden Ansprüche, **dadurch gekennzeichnet, dass** der Substrathalter vom Gasstrom drehangetrieben wird.

7. Verfahren nach Anspruch 6, **dadurch gekennzeichnet, dass** der Substrathalterträger (1) um eine Zentralachse drehangetrieben wird.

8. Verfahren nach einem der vorangehenden Ansprüche, **dadurch gekennzeichnet, dass** die Temperaturmessung durch eine Öffnung (11) einer Prozesskammerdecke (10) erfolgt.

9. Verfahren nach einem der vorangehenden Ansprüche, **dadurch gekennzeichnet, dass** die Substratoberflächentemperaturen während des gesamten Behandlungsprozesses gemessen werden und die Zusammensetzung des das dynamische Gaspolster (8) bildenden Gasstromes während der Behandlung als Funktion des radial gemessenen Temperaturverlaufs der Substrattemperatur variiert wird.

10. Verfahren nach einem der vorangehenden Ansprüche, **dadurch gekennzeichnet, dass** ein Substrathalter (2) verwendet wird, dessen Wärmeleiteigenschaften in Achsrichtung und/oder Wärmestrahlungseigenschaften an unterschiedlichen Radialpositionen verschieden sind.

11. Verfahren nach einem der vorangehenden Ansprüche, **dadurch gekennzeichnet, dass** ein Gaspolster (8) verwendet wird, dessen Höhe am Rand geringer ist als im Zentrum.

12. Vorrichtung zur Durchführung des Verfahrens gemäß der vorangehenden Ansprüche mit einer Prozesskammer (12), einem darin angeordneten Substrathalterträger (1), mindestens einem Substrathalter (2), einer Heizung zum Aufheizen des Substrathalterträgers (1), einer optischen Temperaturmesseinrichtung (3) zur Messung der Oberflächentemperatur mindestens eines auf dem Substrathalter (2) aufliegenden Substrats (9) und mit einer Gaszuleitung (6) zur Zuleitung eines Gasstroms zur Erzeugung eines dynamischen Gaspolsters (8) zwischen einer Unterseite des Substrathalters (2) und einer Bodenfläche einer Lagerausnehmung (20) des Substrathalterträgers (1), in welcher der Substrathalter (2) gelagert ist, mit einer der Gaszuleitung (6) zugeordneten Gasmischeinrichtung (15,16,17,18), in welcher die Zusammensetzung des Gasstroms aus einem schwach wärmeleitenden und einem stark wärmeleitenden einstellbar ist, **dadurch gekennzeichnet, dass** mit der Temperaturmesseinrichtung (3) Oberflächentemperaturen an voneinander verschiedenen Stellen auf der Substratoberfläche messbar sind und der Substrathalter (2) eine derartige Wärmeleitfähigkeit aufweist und die Unterseite des Substrathalters (2) sowie die Bodenfläche der Lageröffnung (20) eine derartige Gestalt besitzen, dass die Oberflächentemperatur des auf dem Substrathalter (2) aufliegenden Substrats (9) bei der Verwendung nur eines der beiden Gase eine rotationssymmetrische laterale Inhomogenität aufweist, die durch Änderung der Zusammensetzung des Gasstroms ausgleichbar und überkompensierbar ist.

13. Vorrichtung nach Anspruch 12, **dadurch gekennzeichnet, dass** der Boden (21) der Lagerausnehmung (20) eine im wesentlichen rotationssymmetrische Unebenheit aufweist und insbesondere gewölbt ist.

14. Vorrichtung nach Anspruch 12 oder 13, **dadurch gekennzeichnet, dass** die dem Boden (21) der Lagerausnehmung (20) gegenüberliegende Unterseite des Substrathalters (2) eine im wesentlichen rotationssymmetrische, von einer Ebenen abweichende Struktur aufweist und insbesondere gewölbt ist.

15. Vorrichtung nach einem der Ansprüche 11 bis 14, **dadurch gekennzeichnet, dass** der Substrathalter (2) in der Mitte dünner ist als am Rand.

16. Vorrichtung nach einem der Ansprüche 11 bis 15, **dadurch gekennzeichnet, dass** das Substrat (9) in einer von einem Randsteg (23) gebildeten Ausnehmung (22) der Oberseite des Substrathalters (2) einliegt.

## Claims

1. Method for controlling the surface temperature of at least one substrate (9) resting on a substrate holder (2) lying in a bearing recess (20) of a substrate holder carrier (1) and carried on a dynamic gas cushion (8) formed by a gas stream, in a process chamber (12) of a CVD reactor, the gas cushion (8) between the bottom surface of the bearing recess (20) and the underside of the substrate (2) being formed by two or more gases (17, 18) with different specific thermal conductivities, and the supply of heat to the substrate (9) being effected at least partly by thermal conduction via the gas cushion, and the surface temperature of the substrate being measured on the substrate surface and the heat-conducting property of the gas cushion being influenced by variation of the gas composition, **characterized in that** the surface temperature of the substrate is measured at a multiplicity of points and the deviations of these temperatures from a mean value is reduced by variation of the gas composition according to the surface temperatures measured, the thermal conductivity of the substrate holder (2) being chosen, and the underside of the substrate (2) and the bottom surface of the bearing recess (20) being configured, such that, when only one of the two gases (17, 18) is used, the surface temperature of the substrate has a rotationally symmetrical lateral inhomogeneity that is compensated or overcompensated by changing the composition of the gas stream.

2. Method according to Claim 1, **characterized in that**, by variation of the gas composition, the lateral variation in temperature on the surface of the substrate holder (2) is influenced in such a way that the temperature on the substrate surface is constant over substantially the entire substrate surface.

3. Method according to either of the preceding claims, **characterized in that**, when only one gas (17, 18) is used, in particular the highly heat-conducting gas, the central region of the substrate holder (2) is warmer than the edge region.

4. Method according to either of Claims 1 and 2, **characterized in that**, when only one gas (17, 18) is used, in particular the poorly heat-conducting gas, the central region of the substrate holder (2) is colder than the edge region.

5. Method according to any of the preceding claims, **characterized in that**, by variation of the individually-controlled gas streams, producing the gas cushions (8), of individual substrate holders (2) of a multiplicity of substrate holders (2) associated with a substrate holder carrier (1), the heights of the gas cushions (8) are regulated such that the measured mean values lie within a given temperature window.

6. Method according to any of the preceding claims, **characterized in that** the substrate holder is rotationally driven by the gas stream.

7. Method according to Claim 6, **characterized in that** the substrate holder carrier (1) is rotationally driven about a central axis.

8. Method according to any of the preceding claims, **characterized in that** the temperature measurement is performed through an opening (11) in a process chamber ceiling (10).

9. Method according to any of the preceding claims, **characterized in that** the substrate surface temperatures are measured during the entire treatment process and the composition of the gas stream forming the dynamic gas cushion (8) is varied during the treatment as a function of the radially measured variation in temperature of the substrate temperature.

10. Method according to any of the preceding claims, **characterized in that** a substrate holder (2) of heat-conducting properties that are different in the axial direction and/or heat-radiating properties that are different at different radial positions is used.

11. Method according to any of the preceding claims, **characterized in that** a gas cushion (8) of a height that is lower at the edge than at the centre is used.

12. Apparatus for carrying out the method according to any of the preceding claims, comprising a process chamber (12), a substrate holder carrier (1) disposed therein, at least one substrate holder (2), a heater for heating up the substrate holder carrier (1), an optical temperature measuring device (3) for measuring the surface temperature of at least one substrate (9) resting on the substrate holder (2) and comprising a gas supply line (6) for supplying a gas stream to produce a dynamic gas cushion (8) between an underside of the substrate holder (2) and a bottom surface of a bearing recess (20) of the substrate holder carrier (1) in which the substrate holder (2) is supported, comprising a gas mixing device (15, 16, 17, 18), which is associated with the gas supply line (6) and in which the composition of the gas stream made up of a poorly heat-conducting gas and a highly heat-conducting gas can be set, **characterized in that** surface temperatures can be measured by the temperature measuring device (3) at points on the substrate surface that are different from one another and the substrate holder (2) has such a thermal conductivity, and the underside of the substrate holder (2) and the bottom surface of the bearing opening (20) have such a shape, that, when only one of the two gases is used, the surface temperature of the substrate (9) resting on the substrate holder (2) has a rotationally symmetrical lateral inhomogeneity that can be compensated and overcompensated by changing the composition of the gas stream.

13. Apparatus according to Claim 12, **characterized in that** the bottom (21) of the bearing recess (20) has a substantially rotationally symmetrical non-planarity, and in particular is curved.

14. Apparatus according to Claim 12 or 13, **characterized in that** the underside of the substrate holder (2), lying opposite the bottom (21) of the bearing recess (20), has a substantially rotationally symmetrical structure deviating from a plane, and in particular is curved.

15. Apparatus according to any of Claims 11 to 14, **characterized in that** the substrate holder (2) is thinner at the centre than at the edge.

16. Apparatus according to any of Claims 11 to 15, **characterized in that** the substrate (9) lies in a recess (22) in the upper side of the substrate holder (2) that is defined by a peripheral web (23).

## Revendications

1. Procédé de commande de la température de surface d'au moins un substrat (9) qui est placé dans une cavité de logement (20) d'un support de porte-substrat (11) se trouvant dans une chambre de réaction (12) d'un réacteur CVD et qui repose sur un porte-substrat (2) supporté par des coussins de gaz dynamiques (8) formés par un flux de gaz, le flux de gaz qui réalise le coussin de gaz (8) entre la surface de fond de la cavité de logement (20) et le côté inférieur du porte-substrat (2) étant formé par deux gaz ou plus (17, 18) présentant des conductivités thermiques spécifiques différentes, et l'amenée de chaleur au substrat (9) étant effectuée au moins partiellement en dirigeant de la chaleur sur le coussin de gaz et la température de surface du substrat étant mesurée à la surface du substrat et la propriété de conductivité thermique du coussin de gaz étant influencée en faisant varier la composition du gaz, **caractérisé en ce que** la température de surface du substrat est mesurée en un grand nombre d'endroits et les écarts de ces températures par rapport d'une valeur moyenne étant évités en faisant varier la composition du gaz en fonction des températures de surface mesurées, la conductivité thermique du porte-substrat (2) étant choisie et le côté inférieur du porte-substrat (2) ainsi que la surface de fond de la cavité de logement (20) étant conformés de telle sorte que la température de surface du substrat présente, lorsque l'on n'utilise qu'un seul des deux gaz (17, 18), une hétérogénéité latérale à symétrie de révolution qui est compensée ou surcompensée en faisant varier la composition du flux de gaz.

2. Procédé selon la revendication 1, **caractérisé en ce que**, en faisant varier la composition du gaz, on modifie la courbe de température latérale à la surface du porte-substrat (2) de sorte que la température à la surface du substrat est constante sur sensiblement toute la surface du substrat.

3. Procédé selon l'une des revendications précédentes, **caractérisé en ce que**, lorsque l'on n'utilise qu'un seul gaz (17, 18), notamment du gaz présentant une forte conductivité thermique, la région centrale du porte-substrat (2) est plus chaude que la région en bordure.

4. Procédé selon l'une des revendications 1 à 2, **caractérisé en ce que**, lorsque l'on n'utilise qu'un seul gaz (17, 18), notamment du gaz de faible conductivité thermique, la région centrale du porte-substrat (2) est plus froide que la région en bordure.

5. Procédé selon l'une des revendications précédentes, **caractérisé en ce que**, en faisant varier les flux de gaz, commandés individuellement et générant les coussins de gaz (8), de chacun d'un grand nombre de porte-substrats (2) associés à un support de porte-substrats (1), on règle les hauteurs des coussins de gaz (8) de sorte que les valeurs moyennes mesurées se trouvent dans une fenêtre de température prédéterminée.

6. Procédé selon l'une des revendications précédentes, **caractérisé en ce que** le porte-substrat est entraîné en rotation par le flux de gaz.

7. Procédé selon la revendication 6, **caractérisé en ce que** le support de porte-substrats (1) est entraîné en rotation autour d'un axe central.

8. Procédé selon l'une des revendications précédentes, **caractérisé en ce que** la mesure de température est effectuée par une ouverture (11) ménagée dans le plafond (10) d'une chambre de réaction.

9. Procédé selon l'une des revendications précédentes, **caractérisé en ce que** les températures de surface de substrat sont mesurées pendant tout le processus de traitement et la composition du flux de gaz formant le coussin de gaz dynamique (8) est modifiée pendant le traitement en fonction de la courbe de température mesurée radialement de la température du substrat.

10. Procédé selon l'une des revendications précédentes, **caractérisé en ce que** l'on utilise un porte-substrat (2) dont les propriétés de conductivité thermique dans la direction axiale et/ou les propriétés de rayonnement thermique en différentes positions radiales sont différentes.

11. Procédé selon l'une des revendications précédentes, **caractérisé en ce que** l'on utilise un coussin de gaz (8) dont la hauteur est plus faible en bordure qu'au centre.

12. Dispositif destiné à la mise en oeuvre le procédé selon les revendications précédentes, ledit dispositif comportant une chambre de réaction (12), un support de porte-substrats (11) placé à l'intérieur, au moins un porte-substrat (2), un dispositif de chauffage destiné à chauffer le support de porte-substrats (1), un dispositif optique de mesure de température (3) destiné à mesurer la température de surface d'au moins un substrat (9) placé sur le porte-substrat (2) et une amenée de gaz (6) destinée à amener un flux de gaz pour générer un coussin de gaz dynamique (8) entre le côté inférieur du porte-substrat (2) et une surface de fond d'une cavité de logement (20) du support de porte-substrats (1) dans lequel le porte-substrat (2) est placé, un dispositif de mélange de gaz (15, 16, 17, 18 qui est associé à l'amenée de gaz (6) et dans lequel on peut régler la composition du flux de gaz à partir d'un gaz présentant une faible conductivité thermique et d'un gaz présentant une forte conductivité thermique, **caractérisé en ce que** l'on peut mesurer au moyen du dispositif de mesure de température (3) des températures de surface en des différents endroits sur la surface du substrat et le porte-substrat (2) présente une conductivité thermique telle et le côté inférieur du porte-substrat (2) ainsi que la surface de fond de la cavité de logement (20) ont une forme telle que la température de surface du substrat (9) placé sur le porte-substrat (2) présente, lorsque l'on n'utilise qu'un seul des deux gaz, une hétérogénéité latérale à symétrie de révolution qui peut être compensée et surcompensée en modifiant la composition du flux de gaz.

13. Dispositif selon la revendication 12, **caractérisé en ce que** le fond (21) de la cavité de logement (20) présente une inégalité sensiblement à symétrie de révolution et est notamment incurvé.

14. Dispositif selon la revendication 12 ou 13, **caractérisé en ce que** le côté inférieur du porte-substrat (2), opposé au fond (21) de la cavité de logement (20), possède une structure sensiblement à symétrie de révolution qui s'écarte d'un plan et est notamment incurvé.

15. Dispositif selon l'une des revendications 11 à 14, **caractérisé en ce que** le porte-substrat (2) est plus mince au milieu qu'en bordure.

16. Dispositif selon l'une des revendications 11 à 15, **caractérisé en ce que** le substrat (9) est placé dans une cavité (22), formée par une nervure en bordure (23), du côté supérieur du porte substrat (22).
